# EUROPEAN PATENT SPECIFICATION

(11) **EP 4 060 754 B1**
(45) Date of publication and mention of the grant of the patent: **23.08.2023**
(21) Application number: 21163628.7
(22) Date of filing: 19.03.2021
(51) Int. Cl.: H01L 33/38

(54) **LIGHT-EMITTING DIODE GRAIN STRUCTURE WITH MULTIPLE CONTACT POINTS**
LEUCHTDIODENKORNSTRUKTUR MIT MEHREREN KONTAKTPUNKTEN
STRUCTURE DE GRAIN DE DIODE ÉLECTROLUMINESCENTE AVEC DE MULTIPLES POINTS DE CONTACT

(43) Date of publication of application: 21.09.2022
(73) Proprietor: Excellence Opto. Inc., Miaoli County 35053 (TW)
(72) Inventor: CHEN, Fu-Bang, 35053 Hsinchu Science Park (TW); Huang, Kuo-Hsin, 35053 Hsinchu Science Park (TW)
(74) Representative: 2K Patentanwälte Blasberg Kewitz & Reichel

(56) References cited:
- US-A1- 2002 000 558
- US-A1- 2005 093 002
- US-A1- 2005 199 888
- US-A1- 2007 018 180
- DER-MING KUO ET AL: "Enhanced Light Output of AlGaInP Light Emitting Diodes Using an Indium?Zinc Oxide Transparent Conduction Layer and Electroplated Metal Substrate", APPLIED PHYSICS EXPRESS, JAPAN SOCIETY OF APPLIED PHYSICS; JP, JP, vol. 4, no. 1, 15 December 2010 (2010-12-15), pages 12101-1, XP001560542, ISSN: 1882-0778, DOI: 10.1143/APEX.4.012101 [retrieved on 2010-12-15]

## Description

### FIELD OF THE INVENTION

The present invention relates to a light-emitting diode, and in particular, to a light-emitting diode grain structure with multiple contact points.

### BACKGROUND OF THE INVENTION

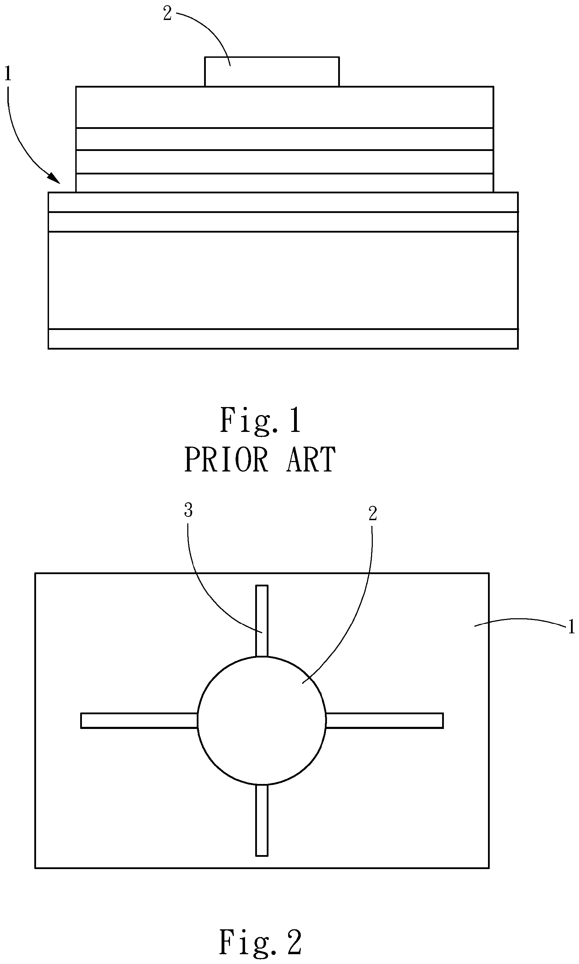

Referring to Fig. 1 and Fig. 2, a vertical light-emitting diode 1 according to the prior art can emit high-efficiency axial light which is very suitable for applications requiring high working current and high illuminance. A general structural design of the vertical light-emitting diode 1 has the following characteristics. An electrode pad 2 is located above the light-emitting diode 1 and is used for wire bonding, and usually a thicker gold wire is used to facilitate passing of a high current. Furthermore, a reference line 3 (Finger) that allows a current to flow vertically to a semiconductor and horizontally through a metal is located above the light-emitting diode 1 in the shape of a finger. If more reference lines 3 are set on the light-emitting diode 1, current dispersion is better, but a shading area would be also increased.

When the electrode pad 2 is formed in a center of the light-emitting diode 1, optical current dispersion is achieved, which can not only improve the luminous efficiency, but also have good heat dissipation. However, the vertical light-emitting diode 1 fails under the following situations: (1) Emitted light is excessively concentrated on the electrode pad 2 and the reference line 3 in a non-uniform manner, which will cause local hot spots so that the light-emitting diode 1 is easy to fail. (2) When a wire is bonded on the electrode pad 2 on a surface of the light-emitting diode 1, there is a risk of damaging a PN junction of the light-emitting diode 1, resulting in a decrease in yield and reliability.

Therefore, the US Patent No. US 8,319,250 B2 provides a multi-conducting pillar technology. In order to make an N-type electrode serve as a bottom electrode and extend to form a plurality of side-wall-insulated vertical conductive pillars passing through a P-type semiconductor layer and a quantum well layer and entering an N-type semiconductor layer, a working current is uniformly dispersed in the N-type semiconductor layer, and a P-type electrode is arranged on a side edge for being used by wire bonding of a package procedure. This design can achieve the best dispersion of the working current via the multiple conductive pillars, and the wire bonding of the packaging procedure will not impact a light-emitting semiconductor layer either, thereby improving the failure mode of the foregoing vertical light-emitting diode 1. However, this structure contains a large number of precise conductive pillars, the diameter of which is usually 20 to 30 µm and the inner cylindrical walls of which are coated with an extremely thin insulation material. A cylindrical center layer is deposited with a highly conductive metal. This structure is fine but fragile, the process is complicated, the cost is high, process conditions are narrow, and failed products are not easy to be detected. The most serious is that when an external stress is extremely high (such as a physical contact with a surface, a deformation stress of the packaging procedure, and the like), the conductive pillars will have micro-cracks, causing an immediate failure of components or a long-term reliability problem. In addition, the design of the plurality of conductive pillars is better for nitride monocrystal optoelectronic semiconductors. For phosphide and arsenide single crystal optoelectronic semiconductors, their chemical properties are relatively unstable and require a lower defect density, so that it is more difficult to make the plurality of conductive pillars, and there is a risk of increasing the defect density. Therefore, this design is not applicable.

Non-patent document DER-MING KUO ET AL: "Enhanced Light Output of AlGaInP Light Emitting Diodes Using an IndiumZinc Oxide Transparent Conduction Layer and Electroplated Metal Substrate", APPLIED PHYSICS EXPRESS, JAPAN SOCIETY OF APPLIED PHYSICS; JP, vol. 4, no. 1, 15 December 2010, pages 12101-1 and patent document US 2002/000558 A1 disclose further light emitting diodes where electrodes comprising layers with different properties and geometries are considered.

### SUMMARY OF THE INVENTION

It is a primary object of the present invention to provide a light-emitting diode grain structure with multiple contact points to disperse a current and reduce a shading area.

This problem is solved by a light-emitting diode grain structure with multiple contact points as claimed by claim 1. Further advantageous embodiments are the subject-matter of the dependent claims.

The invention provides a light-emitting diode grain structure with multiple contact points, including a P-type electrode, a conductive base plate, a light-emitting semiconductor layer, a plurality of ohmic contact metal points, a connection conductive layer, a connection point conductive layer, and an N-type electrode pad. One side of the conductive base plate provided with the P-type electrode. The light-emitting semiconductor layer is arranged on the other side of the conductive base plate, and the light-emitting semiconductor layer comprises a P-type semiconductor layer arranged on the conductive base plate, a quantum well layer arranged on the P-type semiconductor layer, and an N-type semiconductor layer arranged on the quantum well layer. The plurality of ohmic contact metal points is arranged on the N-type semiconductor layer in a spreading manner, and the plurality of ohmic contact metal points contacts with the N-type semiconductor layer. The connection conductive layer is a mesh structure and covering the N-type semiconductor layer, the connection conductive layer is electrically connected to the plurality of ohmic contact metal points without ohmic contact formed between the connection conductive layer and the N-type semiconductor layer. The connection point conductive layer is arranged on the connection conductive layer, and the connection point conductive layer is electrically connected to the connection conductive layer. The N-type electrode pad is arranged on the connection point conductive layer, and the N-type electrode pad is electrically connected to the connection point conductive layer.

Accordingly, compared with the prior art, the invention has the advantages that since no ohmic contact is formed between the connection conductive layer and the N-type semiconductor layer, an operating current would not directly enter the N-type semiconductor layer when the operating current enters the connection conductive layer from the N-type electrode pad via the connection point conductive layer, but would be transmitted to the plurality of ohmic contact metal points via the connection conductive layer, and then enter the N-type semiconductor layer via the plurality of ohmic contact metal points. The plurality of ohmic contact metal points is arranged on the N-type semiconductor layer in a spreading manner, so that the current can be dispersed. In addition, the connection conductive layer is of the mesh structure with a small line width, so that the shading area can be reduced, and the light passing rate is increased. In addition, the invention simultaneously facilitates the light distribution uniformity of an original light source and exciting light after phosphor is coated, and can meet a use requirement of a backlight source of a display.

### BRIEF DESCRIPTION OF THE DRAWINGS

Fig. 1 is a schematic sectional diagram of a conventional structure.
Fig. 2 is a top view of a conventional structure.
Fig. 3 is a schematic sectional diagram of a first embodiment of the invention.
Fig. 4 is a top view of the first embodiment of the invention.
Fig. 5 is a schematic sectional diagram of a second embodiment of the invention.
Fig. 6 is a top view of the second embodiment of the invention.
Fig. 7 is a schematic diagram of current dispersion of the second embodiment of the invention.
Fig. 8 is a schematic diagram of a size of a mesh structure of a conductive layer of the invention.
Fig. 9 is a schematic diagram of implementation of a mesh structure of a conductive layer of the invention.

### DETAILED DESCRIPTION OF THE PREFERRED EMBODIMENTS

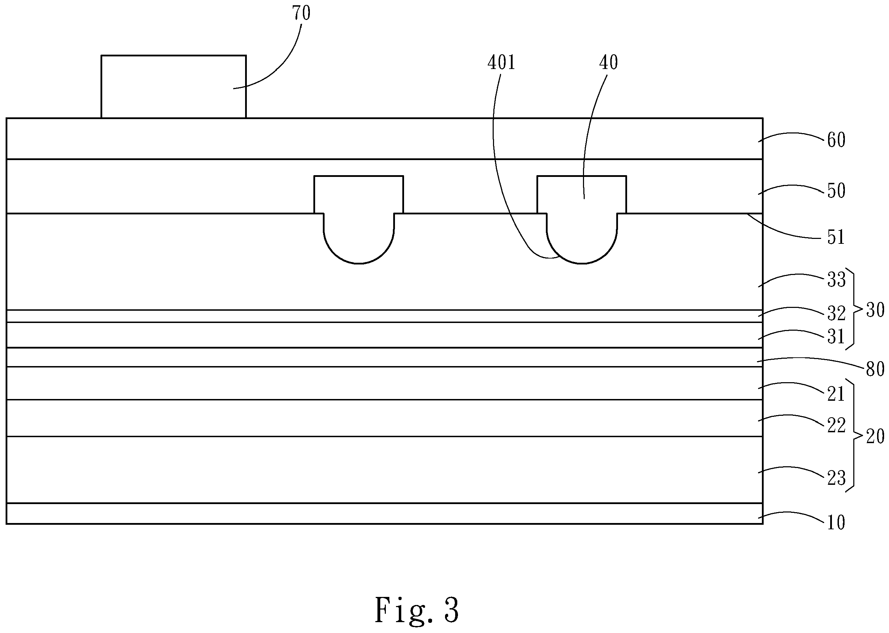

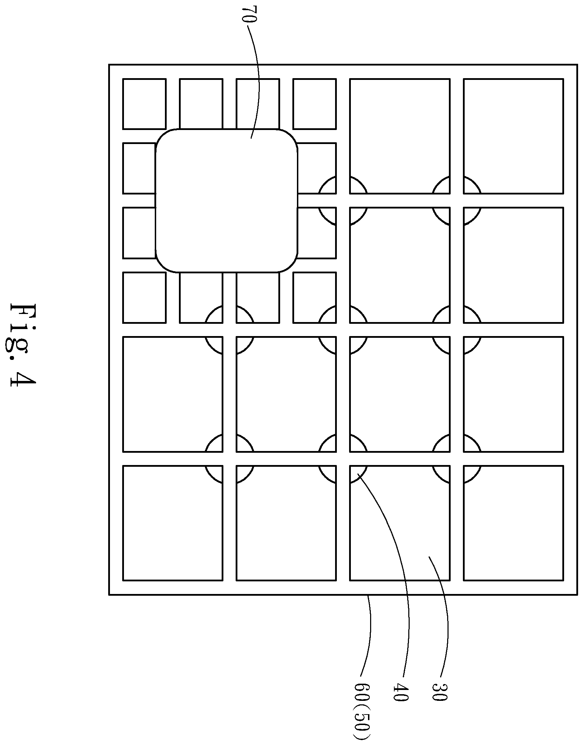

In order to have a deeper understanding and recognition of the features, objectives and effects of the present invention, a preferred embodiment is enumerated and illustrated with the drawings as follows:
Referring to Fig. 3 and Fig. 4, a first embodiment of the invention is illustrated. The invention is a light-emitting diode grain structure with multiple contact points. The light-emitting diode grain structure includes a P-type electrode 10, a conductive base plate 20, a light-emitting semiconductor layer 30, a plurality of ohmic contact metal points 40, a connection conductive layer 50, a connection point conductive layer 60, and an N-type electrode pad 70. One side of the conductive base plate 20 is provided with the P-type electrode 10, and the light-emitting semiconductor layer 30 is arranged on the other side of the conductive base plate 20. In one embodiment, the conductive substrate 20 is provided with a conductive metal light reflection layer 80 in a region adjacent to the light-emitting semiconductor layer 30. The conductive substrate 20 includes a buffer layer 21, a binding layer 22 and a substitutive base plate 23. The light-emitting semiconductor layer 30 is arranged on the buffer layer 21 with the conductive metal light reflection layer 80 therebetween. The P-type electrode 10 is arranged on a side of the substitutive base plate 23 opposite to the light-emitting semiconductor layer 30, and the binding layer 22 adheres and fixes the buffer layer 21 and the substitutive base plate 23. The light-emitting semiconductor layer 30 includes a P-type semiconductor layer 31 arranged on the conductive base plate 20, a quantum well layer 32 and an N-type semiconductor layer 33. The quantum well layer 32 is arranged on the P-type semiconductor layer 31, and the N-type semiconductor layer 33 is arranged on the quantum well layer 32.

The plurality of ohmic contact metal points 40 is arranged on the N-type semiconductor layer 33 of the light-emitting semiconductor layer 30 in a spreading manner, and the plurality of ohmic contact metal points 40 contacts with the N-type semiconductor layer 33. The connection conductive layer 50 is a mesh structure and covers the N-type semiconductor layer 33, the connection conductive layer 50 is electrically connected to the plurality of ohmic contact metal points 40without ohmic contact formed between the connection conductive layer 50 and the N-type semiconductor layer 33. Specifically, the connection conductive layer 50 is made of a highly conductive metal which allows current to flow horizontally, that is, the connection conductive layer 50 conducts with the plurality of ohmic contact metal points 40 without conduction with the N-type semiconductor layer 33 below since an interface of the connection conductive layer 50 has a non-ohmic contact characteristic.

In addition, the connection point conductive layer 60 is arranged on the connection conductive layer 50 and covers the connection conductive layer 50, the connection point conductive layer 60 is electrically connected to the connection conductive layer 50. The connection point conductive layer 60 is a highly conductive and highly stable metal that needs to use a metal with chemical stability. In one embodiment, the connection point conductive layer 60 is made of a material such as gold (Au), platinum (Pt), and aluminum (Al), and the N-type semiconductor layer 33 is a nitride, phosphide or arsenide vertical grain.

The N-type electrode pad 70 is arranged on the connection point conductive layer 60, and the N-type electrode pad 70 is electrically connected to the connection point conductive layer 60. In one embodiment, the N-type electrode pad 70 is located above the N-type semiconductor layer 33. In one embodiment, as shown in Fig. 4, a setting position of the N-type electrode pad 70 is located at a side region of the N-type semiconductor layer 33 so as to avoid shading in wire bonding. Further, in one embodiment, in order to reduce an impact of a subsequent package and wire bonding procedure to the N-type semiconductor layer 33, a thickness of the N-type electrode pad 70 is greater than 2 µm, and the N-type electrode pad 70 is made of gold (Au). Accordingly, the N-type electrode pad 70 is made of a thicker gold with good ductility to absorb the impact force, avoiding damage to the N-type semiconductor layer 33.

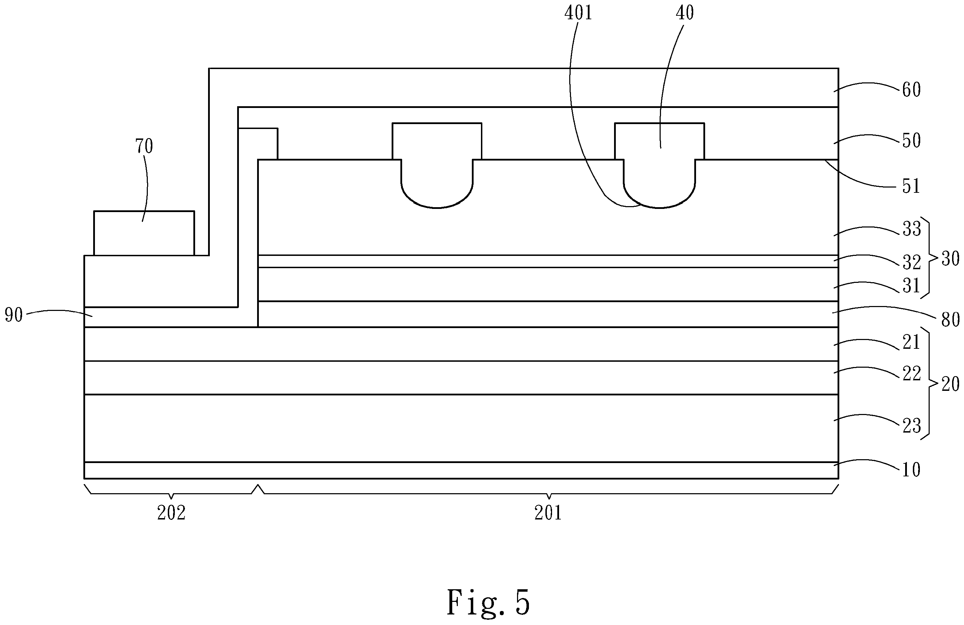

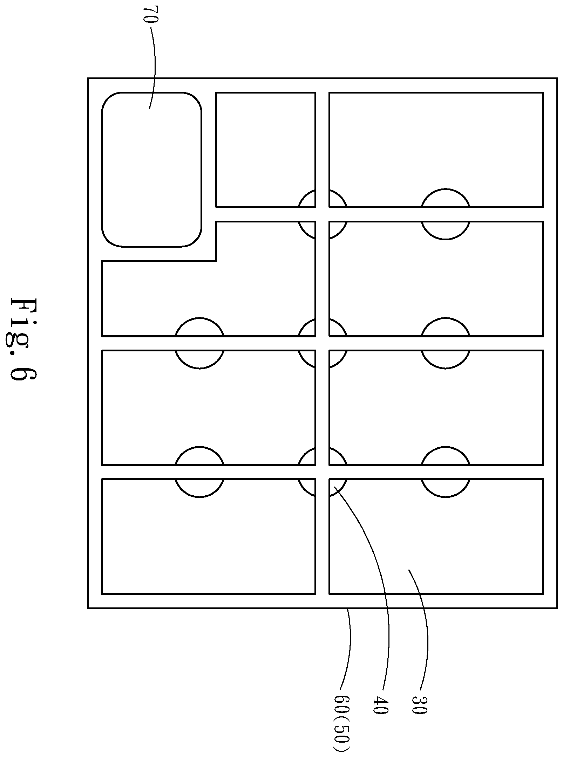

Referring to Fig. 5 and Fig. 6, a second embodiment of the invention is illustrated. Compared with the first embodiment, the second embodiment is that the conductive base plate 20 further includes a center region 201 and a side region 202 adjacent to the center region 201. The light-emitting semiconductor layer 30 is arranged on the center region 201 of the conductive base plate 20, the N-type semiconductor layer 33 and the side region 202 of the conductive base plate 20 are covered by an insulation layer 90. In one embodiment, the insulation layer 90 is made of silicon dioxide (SiO2), silicon nitride (SiN) or titanium dioxide (TiO2), and the like. The connection point conductive layer 60 further extends to the side region 202 of the conductive base plate 20, and is arranged on the insulation layer 90. The N-type electrode pad 70 is located above the side region 202. Accordingly, the N-type electrode pad 70 is not located above the N-type semiconductor layer 33 to avoid bonding damage to the N-type semiconductor layer 33 in the package and wire bonding procedure.

In the two foregoing embodiments, the plurality of ohmic contact metal points 40 includes a small area range, and is preferably circular. A material of the plurality of ohmic contact metal points 40 is a conductive metal to contact with the N-type semiconductor layer 33. For example, when the N-type semiconductor layer 33 is a nitride N-type semiconductor (N-GaN), chromium (Cr), aluminu (Al), titanium (Ti), and indium tin oxide (ITO) can be used as the plurality of ohmic contact metal points 40. When the N-type semiconductor layer 33 is a phosphide N-type semiconductor (N-AlxGa(1-x))0.5In0.5P: X=0-1), GeAu can be used as the plurality of ohmic contact metal points 40. When the N-type semiconductor layer 33 is an arsenide N-type semiconductor (N-AlxGa(1-x))0.5As: X=0-1), NiGeAu, GeAu, and Ti/Pt/Au can be used as the plurality of ohmic contact metal points 40. Therefore, the plurality of ohmic contact metal points 40 is in ohmic contact with the N-type semiconductor.

The connection conductive layer 50 is a conductive material which is in no ohmic contact with the N-type semiconductor layer 33. In actual implementation, there are at least several modes below. A material of the connection conductive layer 50 is a conductive metal that is in non-ohmic contact with the N-type semiconductor layer 33. For example, when the N-type semiconductor layer 33 is a nitride N-type semiconductor (N-GaN), gold (Au), copper (Cu), platinum (Pt), and silver (Ag) can be used as the connection conductive layer 50. When the N-type semiconductor layer 33 is a phosphide N-type semiconductor (N-AlxGa(1-x))0.5In0.5P: X=0-1), gold (Au), copper (Cu), platinum (Pt), silver (Ag), and aluminum (Al) can be used as the connection conductive layer 50. When the N-type semiconductor layer 33 is an arsenide N-type semiconductor (N-AlxGa(1-x))0.5As: X=0-1), gold (Au), copper (Cu), platinum (Pt), silver (Ag), and aluminum (Al) can be used as the connection conductive layer 50. Therefore, the connection conductive layer 50 is in no ohmic contact with the N-type semiconductor layer 33 due to its material characteristic.

In other embodiment, as shown in Fig. 3 or Fig. 5, whether the N-type semiconductor layer 33 is a nitride, phosphide, or arsenide N-type semiconductor, a contact plane 51 between the N-type semiconductor layer 33 and the connection conductive layer 50is passivated through ion bombardment, P-type dispersion or ion implantation, and the contact surface 51 will form an insulation interface and lose the characteristics of an N-type semiconductor, and will not form an ohmic contact with the N-type semiconductor layer 33.

Or, the contact plane 51 between the N-type semiconductor layer 33 and the connection conductive layer 50 is deposited by a thin film and covered by an insulation material, and the nitride, phosphide or arsenide N-type semiconductor can use SiO2, SiN, TiO2, Al2O3, SiC, and the like as the insulation material for thin film deposition, so that an insulation interface can also be formed to avoid the ohmic contact with the N-type semiconductor layer 33.

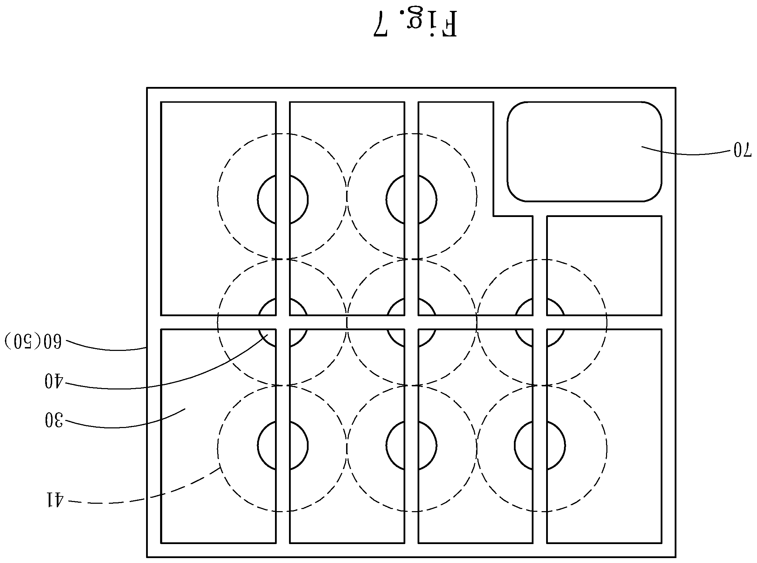

Referring to Fig. 3, Fig. 5, and Fig. 7, when the plurality of ohmic contact metal points 40 contact with the N-type semiconductor layer 33, and no ohmic contact is formed between the connection conductive layer 50 and the N-type semiconductor layer 33, an operating current (not shown) enters the connection conductive layer 50 from the N-type electrode pad 70 via the connection point conductive layer 60, and the current cannot directly enter the N-type semiconductor layer 33, but would be transmitted to the plurality of ohmic contact metal points 40 via the connection conductive layer 50 and then enter the N-type semiconductor layer 33 via the plurality of ohmic contact metal points 40. Therefore, each of the plurality of ohmic contact metal points 40 generates a current dispersion region 41 to effectively disperse the current.

Referring to Fig. 3 or Fig. 5, in order to enhance a luminance of the light-emitting diode grain structure, an electrode reflection plane 401 externally protruding towards the N-type semiconductor layer 33 is arranged between the plurality of ohmic contact metal points 40 and the N-type semiconductor layer 33, so as to improve the light extraction efficiency through multiple reflections of the electrode reflection plane 401 and the conductive metal light reflection layer 80.

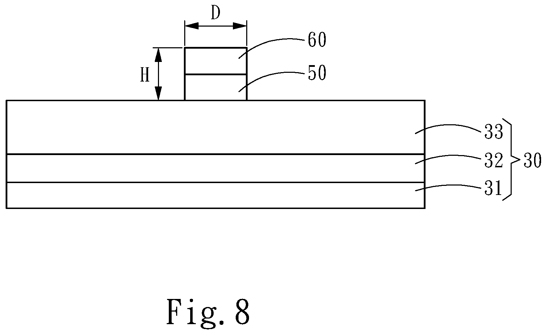

In addition, referring to Fig. 8, in one embodiment, a coverage area rate of the N-type semiconductor layer 33 covered by the connection conductive layer 50 is less than 30% to reduce the shading area of the connection conductive layer 50. In other embodiment, a light shading area is reduced in ways of reducing a line width D of the connection conductive layer 50 and the connection point conductive layer 60, wherein the line width D is controlled between 1 and 10 µm, or reducing quantities and areas of the plurality of ohmic contact metal points 40, and the like. In addition, in order to reduce the impedance of the operating current, the larger the sectional areas of the connection conductive layer 50 and the connection point conductive layer 60, the better. The sectional areas of the connection conductive layer 50 and the connection point conductive layer 60 is a product of an aggregate thickness H of the connection conductive layer 50 and the connection point conductive layer 60 and the line width D. However, increasing the line width D may enlarge the shading area, so that the aggregate thickness H of the connection conductive layer 50 and the connection point conductive layer 60 is increased, but an extremely large aggregate thickness H would cause a collapse problem. More specifically, if a ratio of the thickness H to the line width D is less than 0.5, there would be a shading deficiency that the line width is too extremely wide; and if the ratio is greater than 2.0, there is a collapse risk. Therefore, the ratio of the aggregate thickness H of the connection conductive layer 50 and the connection point conductive layer 60 to the line width D should be close to 1.0 preferably.

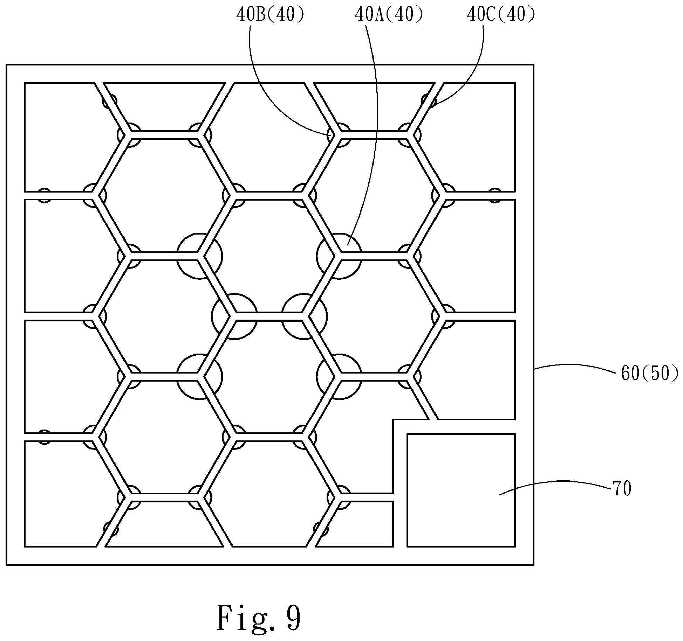

Referring to Fig. 9, the connection conductive layer 50 is located below the connection point conductive layer 60, and is shielded by the connection point conductive layer 60. In one embodiment, an edge of the mesh structure of the connection conductive layer 50 is a closed geometric figure, but it is not limited to this, as long as the connection conductive layer 50 is electrically connected to the plurality of ohmic contact metal points 40. When the edge of the mesh structure of the connection conductive layer 50 is the closed geometric figure, it is represented that there may be more dispersion paths, and manufacturing of symmetric figures is efficient and easy to implement during a semiconductor procedure. As shown in Fig. 9, in one embodiment, the plurality of ohmic contact metal points 40 have different areas according to setting positions on the N-type semiconductor layer 33. More specifically, the areas of the plurality of ohmic contact metal points 40 at different positions may be changed according to an actual need. For example, ohmic contact metal points 40A, 40B, and 40C in three sizes: a large size, a medium size and a small size, can be used, wherein the large-size ohmic contact metal points 40A is arranged in the center region of the N-type semiconductor layer 33 to cause more current passing through the center region of the N-type semiconductor layer 33 to satisfy the light-emitting characteristic of the light-emitting semiconductor layer 30; the medium-size ohmic contact metal points 40B is disposed in an ordinary state; and the small-size ohmic contact metal points 40C is used for correcting distribution of a fine-tune current to meet requirements of actual use. In addition, the connection conductive layer 50 may be of a hexagonal staggered (honeycomb) mesh structure. The hexagonal staggered (honeycomb) mesh structure not only includes a completely closed geometric figure, but an enclosed region with a lower perimeter to area ratio. In addition, each crossing point can be provided with the plurality of ohmic contact metal points 40 to meet a requirement for homogenizing the current.

As mentioned above, the present invention at least includes characteristics as follows:
1. By use of the design that no ohmic contact is formed between the connection conductive layer and the N-type semiconductor layer, there is an ohmic contact formed between the plurality of ohmic contact metal points and the N-type semiconductor layer, and the plurality of ohmic contact metal points are disposed in the spreading manner, the current can be effectively dispersed; light is emitted uniformly, and local hotspots can also be avoided, and the component reliability is increased.
2. The invention has the characteristics of uniform light emission through the design of dispersing current, so that in an application of a nitride white light LED, uniform blue emitted light can be generated, which contributes to the light mixing uniformity after phosphor is excited.
3. The N-type electrode pad is located above the side region rather than on the N-type semiconductor layer, which can prevent the N-type semiconductor layer from being damaged in the package and wire bonding procedure; and in the package procedure, the N-type semiconductor layer is not pulled during wire bonding, so that a risk of cracking or separation is avoided.
4. A ratio of an aggregate thickness of the connection conductive layer and the connection point conductive layer to a line width is controlled to be less than 2.0, to reduce the shading area of the connection conductive layer and the connection point conductive layer to the maximum extent and minimize the current impedance. By use of the design of the electrode reflection plane and the conductive metal light reflection layer, twice oblique reflections can be achieved to reduce light absorption.
5. The procedure of the present invention is simple, and the invention has sufficient structural strength to be suitable for semiconductor materials such as nitrides, phosphides and arsenides, and meet the reliability requirements of various fields.

## Claims

1. A light-emitting diode grain structure with multiple contact points, comprising:
a P-type electrode (10);
a conductive base plate (20), one side of the conductive base plate (20) being provided with the P-type electrode (10);
a light-emitting semiconductor layer (30), arranged on the other side of the conductive base plate (20) and comprising a P-type semiconductor layer (31) arranged on the conductive base plate (20), a quantum well layer (32) arranged on the P-type semiconductor layer (31) and an N-type semiconductor layer (33) arranged on the quantum well layer (32);
a plurality of ohmic contact metal points (40, 40A, 40B, 40C), arranged on the N-type semiconductor layer (33) in a spreading manner and contacting with the N-type semiconductor layer (33);
a connection conductive layer (50), being a mesh structure and covering the N-type semiconductor layer (33), wherein the connection conductive layer (50) is electrically connected to the plurality of ohmic contact metal points (40, 40A, 40B, 40C) without ohmic contact formed between the connection conductive layer (50) and the N-type semiconductor layer (33);
a connection point conductive layer (60), arranged on the connection conductive layer (50) and being electrically connected to the connection conductive layer (50); and
an N-type electrode pad (70), arranged on the connection point conductive layer (60) and being electrically connected to the connection point conductive layer (60).

2. The light-emitting diode grain structure according to claim 1, wherein the conductive base plate (20) comprises a center region (201) and a side region (202) adjacent to the center region (201), the light-emitting semiconductor layer (30) is arranged on the center region (201) of the conductive base plate (20), the N-type semiconductor layer (33) and the side region (202) of the conductive base plate (20) are covered by an insulation layer (90), the connection point conductive layer (60) extends to the side region (202) of the conductive base plate (20) and is arranged on the insulation layer (90), and the N-type electrode pad (70) is located above the side region (202).

3. The light-emitting diode grain structure according to claim 1 or 2, wherein the N-type electrode pad (70) is located above the N-type semiconductor layer (33).

4. The light-emitting diode grain structure according to claim 3, wherein a thickness of the N-type electrode pad (70) is greater than 2 µm and a material of the N-type electrode pad (70) is gold (Au).

5. The light-emitting diode grain structure according to any of the preceding claims, wherein a coverage area rate of the N-type semiconductor layer (33) covered by the connection conductive layer (50) is less than 30%.

6. The light-emitting diode grain structure according to any of the preceding claims, wherein a ratio of an aggregate thickness of the connection conductive layer (50) and the connection point conductive layer (60) to a line width is less than 2.0.

7. The light-emitting diode grain structure according to any of the preceding claims, wherein an edge of the connection conductive layer (50) is a closed geometric figure.

8. The light-emitting diode grain structure according to any of the preceding claims, wherein a material of the connection conductive layer (50) is a conductive metal which is in non-ohmic contact with the N-type semiconductor layer (33).

9. The light-emitting diode grain structure according to any of the preceding claims, wherein a contact plane (51) between the N-type semiconductor layer (33) and the connection conductive layer (50) is passivated through ion bombardment, P-type dispersion or ion implantation.

10. The light-emitting diode grain structure according to any of the preceding claims, wherein a contact plane (51) between the N-type semiconductor layer (33) and the connection conductive layer (50) is covered by an insulation material deposited by a thin film deposition.

11. The light-emitting diode grain structure according to any of the preceding claims, wherein a material of the plurality of ohmic contact metal points (40, 40A, 40B, 40C) is a conductive metal which is contacted with the N-type semiconductor layer (33).

12. The light-emitting diode grain structure according to any of the preceding claims, wherein an electrode reflection plane (401) externally protruding towards the N-type semiconductor layer (33) is arranged between the plurality of ohmic contact metal points (40, 40A, 40B, 40C) and the N-type semiconductor layer (33), and the conductive base plate (20) is provided with a conductive metal light reflection layer (80) in a region adjacent to the light-emitting semiconductor layer (30).

13. The light-emitting diode grain structure according to any of the preceding claims, wherein the plurality of ohmic contact metal points (40, 40A, 40B, 40C) have different areas according to setting positions on the N-type semiconductor layer (33).

## Patentansprüche

1. Leuchtdioden_Kornstruktur mit mehreren Kontaktpunkten, umfassend:
eine P-Typ-Elektrode (10);
eine leitende Grundplatte (20), wobei eine Seite der leitenden Grundplatte (20) mit der P-Typ-Elektrode (10) versehen ist;
eine lichtemittierende Halbleiterschicht (30), die auf der anderen Seite der leitenden Grundplatte (20) angeordnet ist und eine auf der leitenden Grundplatte (20) angeordnete P-Typ-Halbleiterschicht (31), eine auf der P-Typ-Halbleiterschicht (31) angeordnete Quantentopfschicht (32) und eine auf der Quantentopfschicht (32) angeordnete N-Typ-Halbleiterschicht (33) umfasst;
eine Vielzahl von ohmschen Kontakt-Metallpunkten (40, 40A, 40B, 40C), die auf der N-Typ-Halbleiterschicht (33) in einer verteilten Weise angeordnet sind und mit der N-Typ-Halbleiterschicht (33) in Kontakt stehen;
eine leitende Verbindungsschicht (50), die eine Maschenstruktur ist und die N-Typ-Halbleiterschicht (33) bedeckt, wobei die leitende Verbindungsschicht (50) elektrisch mit den mehreren ohmschen Kontakt-Metallpunkten (40, 40A, 40B, 40C) verbunden ist, ohne dass zwischen der leitenden Verbindungsschicht (50) und der N-Typ-Halbleiterschicht (33) ein ohmscher Kontakt ausgebildet ist;
eine leitende Verbindungspunkt-Schicht (60), die auf der leitenden Verbindungsschicht (50) angeordnet und elektrisch mit der leitenden Verbindungsschicht (50) verbunden ist; und
ein N-Typ-Elektrodenpad (70), das auf der leitenden Verbindungspunkt-Schicht (60) angeordnet ist und elektrisch mit der leitenden Verbindungspunkt-Schicht (60) verbunden ist.

2. Leuchtdioden-Kornstruktur nach Anspruch 1, wobei die leitende Grundplatte (20) einen Mittelbereich (201) und einen an den Mittelbereich (201) angrenzenden Seitenbereich (202) aufweist, die lichtemittierende Halbleiterschicht (30) auf dem Mittelbereich (201) der leitenden Grundplatte (20) angeordnet ist, die N-Typ-Halbleiterschicht (33) und der Seitenbereich (202) der leitenden Grundplatte (20) von einer Isolierschicht (90) bedeckt sind, die leitende Verbindungspunkt-Schicht (60) sich bis zu dem Seitenbereich (202) der leitenden Grundplatte (20) erstreckt und auf der Isolierschicht (90) angeordnet ist, und das N-Typ-Elektrodenpad (70) über dem Seitenbereich (202) angeordnet ist.

3. Leuchtdioden-Kornstruktur nach Anspruch 1 oder 2, wobei das N-Typ-Elektrodenpad (70) oberhalb der N-Typ-Halbleiterschicht (33) angeordnet ist.

4. Leuchtdioden-Kornstruktur nach Anspruch 3, wobei die Dicke des N-Typ-Elektrodenpads (70) größer als 2 µm ist und das Material des N-Typ-Elektrodenpads (70) Gold (Au) ist.

5. Leuchtdioden-Kornstruktur nach einem der vorhergehenden Ansprüche, wobei der Bedeckungsgrad der N-Typ-Halbleiterschicht (33), die von der leitenden Verbindungsschicht (50) bedeckt ist, weniger als 30% beträgt.

6. Leuchtdioden-Kornstruktur nach einem der vorhergehenden Ansprüche, wobei das Verhältnis der Gesamtdicke der leitenden Verbindungsschicht (50) und der leitenden Verbindungspunkt-Schicht (60) zu einer Linienbreite kleiner als 2,0 ist.

7. Leuchtdioden-Kornstruktur nach einem der vorangehenden Ansprüche, wobei eine Kante der leitenden Verbindungsschicht (50) eine geschlossene geometrische Figur ist.

8. Leuchtdioden-Kornstruktur nach einem der vorhergehenden Ansprüche, wobei ein Material der leitenden Verbindungsschicht (50) ein leitendes Metall ist, das in einem nichtohmischen Kontakt mit der N-Typ-Halbleiterschicht (33) steht.

9. Leuchtdioden-Kornstruktur nach einem der vorhergehenden Ansprüche, wobei eine Kontaktebene (51) zwischen der N-Typ-Halbleiterschicht (33) und der leitenden Verbindungsschicht (50) durch Ionenbeschuss, P-Typ-Dispersion oder Ionendotierung passiviert ist.

10. Leuchtdioden-Kornstruktur nach einem der vorhergehenden Ansprüche, wobei eine Kontaktebene (51) zwischen der N-Typ-Halbleiterschicht (33) und der leitenden Verbindungsschicht (50) mit einem durch Dünnfilm- Abscheidung abgeschiedenen Isolationsmaterial bedeckt ist.

11. Leuchtdioden-Kornstruktur nach einem der vorhergehenden Ansprüche, wobei ein Material der mehreren ohmschen Kontakt-Metallpunkte (40, 40A, 40B, 40C) ein leitendes Metall ist, das mit der N-Halbleiterschicht (33) in Kontakt steht.

12. Leuchtdioden-Kornstruktur nach einem der vorhergehenden Ansprüche, wobei zwischen der Vielzahl der ohmschen Kontakt-Metallpunkte (40, 40A, 40B, 40C) und der N-Typ-Halbleiterschicht (33) eine Elektroden-Reflexionsebene (401) angeordnet ist, die nach außen in Richtung der N-Typ-Halbleiterschicht (33) vorsteht, und die leitende Grundplatte (20) in einem an die lichtemittierende Halbleiterschicht (30) angrenzenden Bereich mit einer leitenden Metall-Lichtreflexionsschicht (80) versehen ist.

13. Leuchtdioden-Kornstruktur nach einem der vorhergehenden Ansprüche, wobei die mehreren ohmschen Kontakt-Metallpunkte (40, 40A, 40B, 40C) entsprechend den Einstellpositionen auf der N-Typ-Halbleiterschicht (33) unterschiedliche Flächeninhalte aufweisen.

## Revendications

1. Une structure de grain de diode électroluminescente avec points de contact multiples, comprenant :
une électrode de type P (10)
une plaque de base conductrice (20), un côté de la plaque de base conductrice (20) étant pourvu de l'électrode de type P (10) ;
une couche semi-conductrice électroluminescente (30), disposée sur l'autre côté de la plaque de base conductrice (20) et comprenant une couche semi-conductrice de type P (31) disposée sur la plaque de base conductrice (20), une couche de puits quantique (32) disposée sur la couche semi-conductrice de type P (31) et une couche semi-conductrice de type N (33) disposée sur la couche de puits quantique (32) ;
une pluralité de points métalliques de contact ohmique (40, 40A, 40B, 40C), disposés sur la couche semi-conductrice de type N (33) de manière étalée et en contact avec la couche semi-conductrice de type N (33) ;
une couche conductrice de connexion (50), constituée d'une structure maillée et recouvrant la couche semi-conductrice de type N (33), dans laquelle la couche conductrice de connexion (50) est électriquement connectée à la pluralité de points métalliques de contact ohmique (40, 40A, 40B, 40C) sans contact ohmique formé entre la couche conductrice de connexion (50) et la couche semi-conductrice de type N (33) ;
une couche conductrice de point de connexion (60), disposée sur la couche conductrice de connexion (50) et connectée électriquement à la couche conductrice de connexion (50) ; et
un plot d'électrode de type N (70), disposé sur la couche conductrice de point de connexion (60) et connecté électriquement à la couche conductrice de point de connexion (60).

2. La structure de grain de diode électroluminescente selon la revendication 1, dans laquelle la plaque de base conductrice (20) comprend une région centrale (201) et une région latérale (202) adjacente à la région centrale (201), la couche semi-conductrice électroluminescente (30) est disposée sur la région centrale (201) de la plaque de base conductrice (20), la couche semi-conductrice de type N (33) et la zone latérale (202) de la plaque de base conductrice (20) sont recouvertes d'une couche d'isolation (90), la couche conductrice de point de connexion (60) s'étend jusqu'à la zone latérale (202) de la plaque de base conductrice (20) et est disposée sur la couche d'isolation (90), et le plot d'électrode de type N (70) est situé au-dessus de la zone latérale (202).

3. La structure de grain de diode électroluminescente selon la revendication 1 ou 2, dans laquelle le plot d'électrode de type N (70) est situé au-dessus de la couche semi-conductrice de type N (33).

4. La structure de grain de diode électroluminescente selon la revendication 3, dans laquelle une épaisseur du plot d'électrode de type N (70) est supérieure à 2 µm et un matériau du plot d'électrode de type N (70) est l'or (Au).

5. La structure de grain de diode électroluminescente selon l'une quelconque des revendications précédentes, dans laquelle un taux de surface de couverture de la couche semi-conductrice de type N (33) recouverte par la couche conductrice de connexion (50) est inférieur à 30 %.

6. La structure de grain de diode électroluminescente selon l'une quelconque des revendications précédentes, dans laquelle le rapport entre l'épaisseur totale de la couche conductrice de connexion (50) et de la couche conductrice de point de connexion (60) et la largeur d'une ligne est inférieur à 2,0.

7. La structure de grain de diode électroluminescente selon l'une quelconque des revendications précédentes, dans laquelle un bord de la couche conductrice de connexion (50) est une figure géométrique fermée.

8. La structure de grain de diode électroluminescente selon l'une quelconque des revendications précédentes, dans laquelle un matériau de la couche conductrice de connexion (50) est un métal conducteur qui est en contact non ohmique avec la couche semi-conductrice de type N (33).

9. La structure de grain de diode électroluminescente selon l'une quelconque des revendications précédentes, dans laquelle un plan de contact (51) entre la couche semi-conductrice de type N (33) et la couche conductrice de connexion (50) est passivé par bombardement ionique, dispersion de type P ou implantation ionique.

10. La structure de grain de diode électroluminescente selon l'une quelconque des revendications précédentes, dans laquelle un plan de contact (51) entre la couche semi-conductrice de type N (33) et la couche conductrice de connexion (50) est recouvert d'un matériau isolant déposé par un film mince.

11. La structure de grain de diode électroluminescente selon l'une quelconque des revendications précédentes, dans laquelle un matériau de la pluralité de points métalliques de contact ohmique (40, 40A, 40B, 40C) est un métal conducteur qui est en contact avec la couche semi-conductrice de type N (33).

12. La structure de grain de diode électroluminescente selon l'une quelconque des revendications précédentes, dans laquelle un plan de réflexion d'électrode (401) faisant saillie extérieurement vers la couche semi-conductrice de type N (33) est disposé entre la pluralité de points métalliques de contact ohmique (40, 40A, 40B, 40C) et la couche semi-conductrice de type N (33), et la plaque de base conductrice (20) est pourvue d'une couche métallique conductrice de réflexion de la lumière (80) dans une région adjacente à la couche semi-conductrice électroluminescente (30).

13. La structure de grain de diode électroluminescente selon l'une quelconque des revendications précédentes, dans laquelle la pluralité de points métalliques de contact ohmique (40, 40A, 40B, 40C) ont des zones différentes en fonction des positions de réglage sur la couche semi-conductrice de type N (33).
